**Europäisches Patentamt**

**European Patent Office**

**Office européen des brevets**

(19)

(11) Veröffentlichungsnummer: **0 221 278**
**B1**

(12) # EUROPÄISCHE PATENTSCHRIFT

(45) Veröffentlichungstag der Patentschrift:
28.02.90

(51) Int. Cl.⁴: **H05K 7/14**

(21) Anmeldenummer: **86112062.4**

(22) Anmeldetag: **01.09.86**

(54) Halterung für an einem Apparategestell angeordnete gedruckte Schaltungen.

(30) Priorität: **17.10.85 CH 4483/85**

(43) Veröffentlichungstag der Anmeldung:
**13.05.87 Patentblatt 87/20**

(45) Bekanntmachung des Hinweises auf die Patenterteilung:
**28.02.90 Patentblatt 90/9**

(84) Benannte Vertragsstaaten:
**AT CH DE FR GB IT LI**

(56) Entgegenhaltungen:
**EP-A- 0 123 872**
**CH-A- 428 878**
**DE-U- 8 502 212**
**FR-A- 2 317 854**
**FR-A- 2 318 558**
**GB-A- 1 573 090**
**US-A- 4 109 300**

(73) Patentinhaber: **INVENTIO AG, Seestrasse 55,
CH-6052 Hergiswil NW(CH)**

(72) Erfinder: **Schröder, Joris, Dr., Schädrütihalde 2,
CH-6006 Luzern(CH)**

## Beschreibung

Die Erfindung betrifft eine Halterung für an einem Apparategestell angeordnete gedruckte Schaltungen, mit am Apparategestell befestigten Tragschienen und mit Haltern, die Führungsnuten aufweisen, in welche die gedruckten Schaltungen eingeschoben sind (siehe z. B. DE-U 8 502 212).

Eine Halterung gemäss dem Oberbegriff des Anspruchs I ist auch bekannt geworden, bei welcher aus zwei Haltern, einem Steckverbinder, einer Halteplatte und einer Montageplatte eine Baugruppe gebildet wird. Diese Baugruppe wird an der Tragschiene derart befestigt, dass eine in die Führungsnuten der Halter eingeschobene gedruckte Schaltung in Längsrichtung der Tragschiene verläuft. Bei normalerweise in horizontaler Lage angeordneten Tragschienen kann es hierbei zu Ablagerungen und damit zu Verschmutzungen der gedruckten Schaltungen kommen. Ausserdem kann die relativ aufwendige Bau- und Montageart dieser Halterung insbesondere bei umfangreicheren Apparategestellen, die eine grössere Anzahl gedruckter Schaltungen aufweisen, zu beträchtlichen Kostensteigerungen führen.

Es ist daher Aufgabe der Erfindung, eine Halterung gemäss Oberbegriff zu schaffen, die bei weniger Aufwand in kürzerer Zeit montierbar ist, und bei der eine Verschmutzung der gedruckten Schaltungen ohne die Verwendung zusätzlicher Abdeckungen weitgehend vermieden wird.

Diese Aufgabe wird durch die im Patentanspruch 1 gekennzeichnete Erfindung gelöst. Hierbei ist jeder Halter eines einer gedruckten Schaltung zugeordneten Halterpaares auf einer anderen Tragschiene angeordnet, wobei die Tragschienen parallel zueinander verlaufen und die Halter unmittelbar auf diesen befestigt sind. Die Befestigung ist derart, dass die Ränder der Tragschienen beim Aufsetzen der Halter in an diesen angebrachte Nuten einrasten. Die Halter weisen eine Klemmeinrichtung auf, mittels der sie nach dem Aufsetzen und Positionieren auf den Tragschienen festgeklemmt werden können.

Die mit der Erfindung erzielten Vorteile liegen darin, dass die Halter in kürzester Zeit an beliebigen Stellen der Tragschienen aufgesetzt, und entsprechend den Bestückungen der gedruckten Schaltungen in platzsparende Positionen verschoben und festgeklemmt werden können.

Da die Halterung einer gedruckten Schaltung bei bereits vorhandenen Tragschienen lediglich aus zwei gleichen Haltern besteht, ergeben sich relativ niedrige Materialkosten. Bei horizontaler Anordnung der Tragschienen verlaufen die gedruckten Schaltungen senkrecht dazu, wodurch Verschmutzung durch Ablagerungen weitgehend vermieden wird. Wird die erfindungsgemässe Halterung auf Normschienen abgestellt, so ergeben sich weitere Vorteile, indem die Halter zusammen mit handelsüblichen Reihenklemmen und anderen für die Befestigung auf Normschienen geeigneten Bauteilen in beliebiger Reihenfolge auf diesen angeordnet werden können.

Im folgenden wird die Erfindung anhand mehrerer auf der Zeichnung dargestellter Ausführungsbeispiele näher erläutert. Es zeigen:

Fig. 1 eine Seitenansicht eines oberen Teiles der Halterung,

Fig. 2 eine Seitenansicht eines unteren Teiles der Halterung mit einem Steckverbinder,

Fig. 3 eine Ansicht mehrerer Halterungen in einem gegenüber den Fig. 1 und 2 verkleinerten Massstab,

Fig. 4 eine Seitenansicht einer Halterung mit zwei Steckverbindern im Massstab der Fig. 1 und 2 und

Fig. 5 eine Befestigung eines Halters auf einer Tragschiene in einem gegenüber den Fig. 1-4 vergrösserten Massstab.

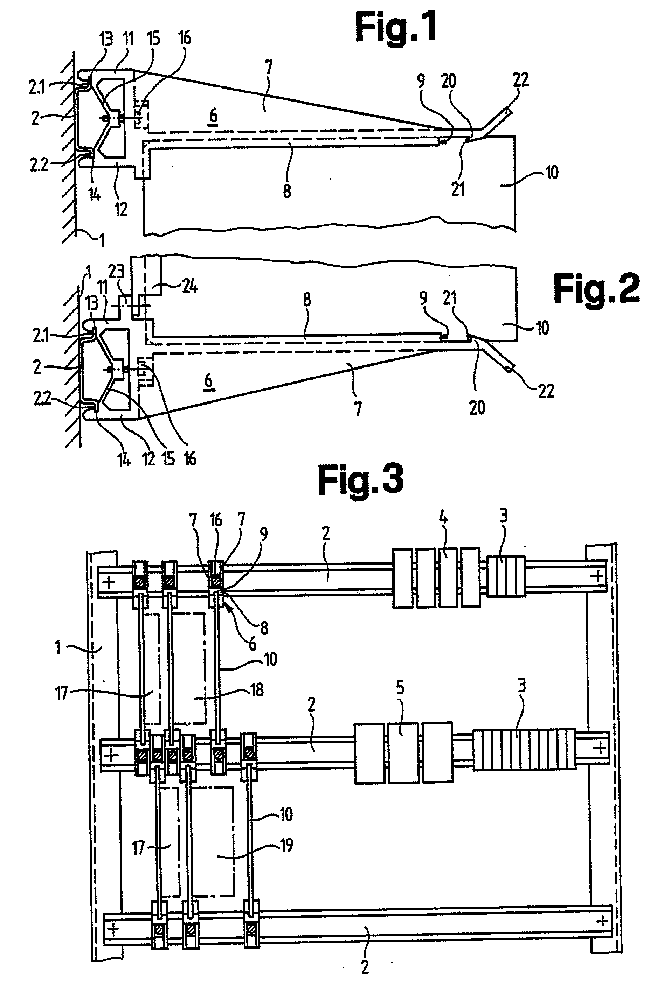

In den Fig. 1 bis 3 ist mit 1 ein Apparategestell bezeichnet, an welchem Tragschienen 2, vorzugsweise im Handel erhältliche Normschienen, in horizontaler Lage parallel zueinander verlaufend befestigt sind. Auf den Tragschienen 2 sind zum Beispiel elektrische Anschlussklemmen 3, Relais 4 oder andere elektrische Bauteile 5 angeordnet. Mit 6 sind Halter bezeichnet, die durch Rippen 7 versteifte Führungsleisten 8 aufweisen, in welchen Führungsnuten 9 zur Aufnahme von gedruckten Schaltungen 10 vorgesehen sind. Jeder Halter 6 eines einer gedruckten Schaltung 10 zugeordneten Halterpaares ist auf einer anderen Tragschiene 2 angeordnet. Bei der beispielsgemässen Ausführung mit drei Tragschienen 2 sind die Halterpaare abwechselnd auf der mittleren und oberen Tragschiene 2 und auf der mittleren und unteren Tragschiene 2 angeordnet. Die Halter 6 sind unmittelbar auf den Tragschienen 2 befestigt, wobei die Befestigung beispielsweise in gleicher Art wie bei im Handel erhältlichen elektrischen Anschlussklemmen 3 erfolgt. Hierbei sind in elastischen Seitenteilen 11, 12 des Halters 6 weitere Nuten 13, 14 vorgesehen, in welche beim Aufsetzen des Halters 6 Ränder 2.1, 2.2 der Tragschiene 2 einrasten. Die Seitenteile 11, 12 sind über einen elastischen Steg 15 miteinander verbunden, der mittels einer Klemmschraube 16 gespannt werden kann, wodurch die Halter 6 nach dem Verschieben in beispielsweise von den Bestückungen 17, 18, 19 der gedruckten Schaltungen 10 abhängige Positionen auf den Tragschienen 2 festgeklemmt werden können. Am oberen Ende der Führungsleiste 8 ist ein Vorsprung 20 vorgesehen, der beim Einschieben der gedruckten Schaltung 10 in eine an dieser angebrachten Kerbe 21 einrastet. Die Führungsleiste 8 weist am oberen Ende ausserdem eine Abwinkelung 22 auf, mittels welcher beim Herausziehen der gedruckten Schaltung 10 der Vorsprung 20 aus der Kerbe 21 gedrückt werden kann. Bei der Ausführung gemäss Fig. 2 ist am Halter 6 ein Ansatz 23 für die Befestigung eines Steckverbinders 24 vorgesehen.

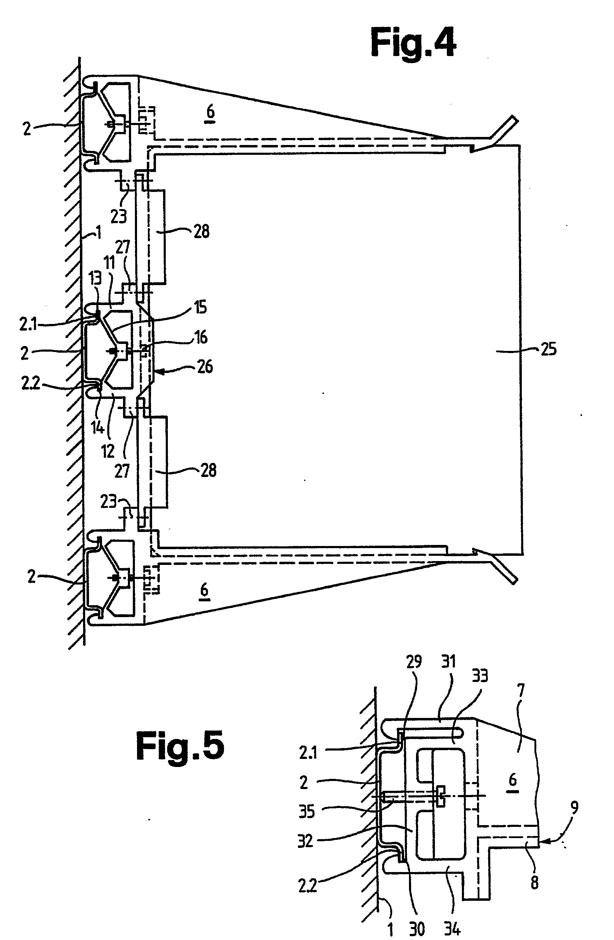

Gemäss Fig. 4 sind die Halter 6 eines einer breiteren gedruckten Schaltung 25 zugeordneten Halterpaares auf der oberen und unteren Tragschiene 2 angeordnet. Auf der mittleren Tragschiene 2 ist ein Steckverbinderhalter 26 vorgesehen, der zwei Ansätze 27 für die Befestigung von zwei Steckverbindern 28 aufweist, die jeweils anderenends an den Ansätzen 23 von auf der oberen bzw. unteren Tragschiene 2 sitzenden Haltern 6 befestigt sind. Die Befestigung des Steckverbinderhalters 26 erfolgt in gleicher Weise wie die vor- oder nachstehend beschriebene Befestigung der Halter 6.

In der Fig. 5 sind mit 29 und 30 im Halter 6 vorgesehene weitere Nuten bezeichnet. Die eine der beiden Nuten 29 wird durch ein elastisches Teil des Halters 6 in Form eines Rasthebels 31 und einen Steg 32 gebildet, welcher Seitenteile 33, 34 des Halters miteinander verbindet. Beim Aufsetzen des Halters 6 rasten die Ränder 2.1, 2.2 der Tragschiene 2 in die weiteren Nuten 29, 30 ein, wonach der Halter 6 mittels einer durch den Steg 32 und eine in diesen eingeschraubte Klemmschraube 35 gebildete Klemmeinrichtung festgeklemmt werden kann. Hierbei stützt sich die Klemmschraube 35 im angezogenen Zustand auf der Tragschiene 2 ab, so dass der Halter 6 und die Tragschiene 2 in den weiteren Nuten 29, 30 gegeneinander verspannt werden.

Es liegt im Rahmen der Erfindung, dass anstelle von bestückten oder unbestückten gedruckten Schaltungen 10, 25 auch andere, mit passenden Rändern versehene elektrische Bauteile oder Baugruppen in die Halter 6 eingeschoben werden können.

## Patentansprüche

1. Halterung für an einem Apparategestell angeordnete gedruckte Schaltungen, mit am Apparategestell (1) befestigten Tragschienen (2) und mit Haltern (6), die Führungsnuten (9) aufweisen, in welche die gedruckten Schaltungen (10) eingeschoben sind, **dadurch gekennzeichnet,** dass jeder Halter (6) eines einer gedruckten Schaltung (10) zugeordneten Halterpaares auf einer anderen Tragschiene (2) angeordnet ist, wobei die Tragschienen (2) parallel zueinander verlaufen und die Halter (6) unmittelbar derart auf diesen befestigt sind, dass Ränder (2.1, 2.2) der Tragschienen (2) in an den Haltern (6) angebrachten weiteren Nuten (13, 14) eingerastet sind, und dass an den Haltern (6) eine Klemmeinrichtung vorgesehen ist, mit der die Halter (6) nach dem Aufsetzen und Positionieren auf den Tragschienen (2) festgeklemmt werden können.

2. Halterung nach Patentanspruch 1, **dadurch gekennzeichnet,** dass der Halter (6) einen Ansatz (23) für die Befestigung eines Steckverbinders (24) aufweist.

3. Halterung nach Patentanspruch 2, **dadurch gekennzeichnet,** dass drei horizontal verlaufende Tragschienen (2) vorgesehen sind, wobei die einer gedruckten Schaltung (10) zugeordneten Halterpaare abwechselnd auf der mittleren und oberen Tragschiene und auf der mittleren und unteren Tragschiene befestigt sind.

4. Halterung nach Patentanspruch 2, **dadurch gekennzeichnet,** dass drei horizontal verlaufende Tragschienen (2) vorgesehen sind, wobei an der oberen und unteren Tragschiene die Halter (6) eines einer gedruckten Schaltung (25) zugeordneten Halterpaares angeordnet sind und auf der mittleren Tragschiene ein Steckverbinderhalter (26) befestigt ist, der zwei Ansätze (27) für die Befestigung von zwei Steckverbindern (28) aufweist, die jeweils anderenends an den Ansätzen (23) der auf der oberen bzw. unteren Tragschiene sitzenden Halter (6) befestigt sind.

5. Halterung nach Patentanspruch 1, **dadurch gekennzeichnet,** dass die Klemmeinrichtung aus einem Steg (32) besteht, in welchen eine Klemmschraube (35) eingeschraubt ist, die sich im angezogenen Zustand auf der Tragschiene (2) abstützt, wobei sich der Halter (6) und die Tragschiene (2) in den weiteren Nuten (29, 30) gegeneinander verspannen.

6. Halterung nach Patentanspruch 5, **dadurch gekennzeichnet,** dass mindestens eine der weiteren Nuten (29) durch ein elastisches Teil des Halters (6) in Form eines federnden Rasthebels (31) und den Steg (32) gebildet wird.

7. Halterung nach Patentanspruch 1, **dadurch gekennzeichnet,** dass an einer die Führungsnut (9) aufweisenden Führungsleiste (8) des Halters (6) ein Vorsprung (20) vorgesehen ist, der beim Einschieben der gedruckten Schaltung (10) in eine an dieser angebrachten Kerbe (21) einrastet, und dass die Führungsleiste (8) am oberen Ende eine Abwinkelung (22) aufweist, mittels welcher beim Herausziehen der gedruckten Schaltung (10) der Vorsprung (20) aus der Kerbe (21) gedrückt werden kann.

## Claims

1. Mounting for printed circuits arranged at an apparatus frame, with carrier rails (2) fastened at the apparatus frame (1) and with holders (6), which display guide grooves (9), into which the printed circuits (10) are pushed, characterised thereby, that each holder (6) of a holder pair associated with a printed circuit (10) is arranged on a different carrier rail (2), wherein the carrier rails (2) extend one parallelly to the other and the holders (6) are fastened directly on these in such a manner that rims (2.1, 2.2) of the carrier rails (2) are detented in further grooves (13, 14) arranged at the holders (6) and that a clamping equipment, by which the holders (6) can be clamped fast on the carrier rails (2) after being placed thereon and positioned, is provided at the holders (6).

2. Mounting according to claim 1, characterised thereby, that the holder (6) displays a projection (23) for the fastening of a plug connector (24).

3. Mounting according to claim 2, characterised thereby, that three horizontally extending carrier rails (2) are provided, wherein the holder pairs associated with a printed circuit (10) are fastened alternately on the middle and upper carrier rail and on the middle and lower carrier rail.

4. Mounting according to claim 2, characterised thereby, that three horizontally extending carrier rails (2) are provided, wherein the holders (6) of a holder pair associated with a printed circuit (25) are arranged at the upper and the lower carrier rail and a plug connector holder (26) is arranged on the middle carrier rail and displays two projections (27) for the fastening of two plug connectors (28), which at the respective other end are fastened at the projections (23) of the holders (6) sitting respectively on the upper and the lower carrier rail.

5. Mounting according to claim 1, characterised thereby, that the clamping equipment consists of a web (32), into which a clamping screw (35) is screwed, which in the tightened state bears on the carrier rail (2), whilst the holder (6) and the carrier rail (2) tighten each against the other in the further grooves (29, 30).

6. Mounting according to claim 5, characterised thereby, that at least one of the further grooves (29) is formed by the web (32) and an elastic part of the holder (6) in the shape of a resilient detent lever (31).

7. Mounting according to claim 1, characterised thereby, that a projection (20), which on the insertion of the printed circuit (10) detents into a notch (21) arranged thereat, is provided in a guide strip (8), which displays the guide groove (9), of the holder (6) and that the guide strip (8) at the upper end displays a bent portion (22), by means of which the projection (20) can be pressed out of the notch (21) on the withdrawal of the printed circuit (10).

**Revendications**

1. Support pour des circuits imprimés arrangés dans un bâti d'appareillage, avec des rails porteurs (2) fixés au bâti d'appareillage (1) et avec des appuis (6) qui comportent des rainures de guidage (9) dans lesquelles les circuits imprimés (10) sont introduits, caractérisé en ce que chacun des appuis (6) d'une paire d'appuis associée à un circuit imprimé (10) est disposé sur un rail porteur (2) respectif, les rails porteurs (2) s'étendant parallèlement l'un à l'autre et les appuis (6) étant directement fixés sur ceux-ci de telle manière que des bords (2.1, 2.2) des rails porteurs (2) sont engagés dans des autres rainures (13, 14) ménagées dans les appuis (6), et en ce que sur les appuis (6) est prévu un dispositif de serrage avec lequel les appuis (6), après la pose et le positionnement sur les rails porteurs (2), peuvent être bloqués sur les rails porteurs.

2. Support selon la revendication 1, caractérisé, en ce que l'appui (6) comporte un épaulement (23) pour la fixation d'un connecteur enfichable (24).

3. Support selon la revendication 2, caractérisé en ce que sont prévus trois rails porteurs (2) s'étendant horizontalement, les paires d'appuis associées à un circuit imprimé (10) étant alternativement fixées sur le rail porteur médian et le rail porteur supérieur et sur le rail porteur médian et le rail porteur inférieur.

4. Support selon la revendication 2, caractérisé en ce que sont prévus trois rails porteurs (2) s'étendant horizontalement, les appuis (6) d'une paire d'appuis associée à un circuit imprimé (25) étant disposés sur les rails porteurs supérieur et inférieur, et un support (26) de connecteur enfichable étant fixé sur le rail porteur médian et comportant deux épaulements (27) pour la fixation de deux connecteurs enfichables (28) fixés respectivement, à l'autre extrémité, aux épaulements (23) des appuis (6) respectivement placés sur les rails porteurs supérieur et inférieur.

5. Support selon la revendication 1, caractérisé en ce que le dispositif de serrage consiste en une entretoise (32) dans laquelle est vissée une vis de pression (35) qui, à l'état de serrage, prend appui sur le rail porteur (2), l'appui (6) et le rail porteur (2) se bloquant l'un contre l'autre par pression dans les autres rainures (29, 30).

6. Support selon la revendication 5, caractérisé en ce qu'au moins une des autres rainures (29) est formée par une partie élastique de l'appui (6) sous forme d'un levier à cran (31) et par l'entretoise (32).

7. Support selon la revendication 1, caractérisé en ce qu'à un listel de guidage (8) de l'appui (6) comportant la rainure de guidage (9) est prévue une saillie (20) qui lors de l'introduction du circuit imprimé (10) s'engage dans une encoche (21) ménagée dans celui-ci, et en ce qu'à l'extrémité supérieure le listel de guidage (8) présente une partie pliée (22) au moyen de laquelle, lors de l'extraction du circuit imprimé (10), la saillie (20) peut être poussée hors de l'encoche (21).

# Fig.1

# Fig.2

# Fig.3

# Fig.4

# Fig.5